# EUROPÄISCHE PATENTSCHRIFT

(11) **EP 1 483 827 B1**
(45) Veröffentlichungstag und Bekanntmachung des Hinweises auf die Patenterteilung: **01.08.2007**
(21) Anmeldenummer: 03706294.0
(22) Anmeldetag: 06.02.2003
(51) Int. Cl.: H03B 21/01, H03D 7/12

(54) **SCHALTUNGSANORDNUNG ZUR FREQUENZUMSETZUNG UND MOBILFUNKGERÄT MIT DER SCHALTUNGSANORDNUNG**
CIRCUIT ARRANGEMENT FOR FREQUENCY CONVERSION AND MOBILE RADIO DEVICE WITH THE CIRCUIT ARRANGEMENT
ENSEMBLE CIRCUIT DE CONVERSION DE FREQUENCE ET APPAREIL RADIOTELEPHONIQUE MOBILE EQUIPE DUDIT ENSEMBLE CIRCUIT

(30) Priorität: 12.03.2002 DE 10210708
(43) Veröffentlichungstag der Anmeldung: 08.12.2004
(73) Patentinhaber: Infineon Technologies AG, 81669 München (DE)
(72) Erfinder: GREWING, Christian, 40489 Düsseldorf (DE); HANKE, André, 40489 Düsseldorf (DE)
(74) Vertreter: Epping - Hermann - Fischer
(86) Internationale Anmeldenummer: PCT/DE2003/000345
(87) Internationale Veröffentlichungsnummer: WO 2003/077413

(56) Entgegenhaltungen:
- US-A- 3 188 483
- US-A- 3 605 023
- US-A1- 2001 054 919
- NUECHTER P ET AL: "A NOVEL FREQUENCY DIVIDER CONFIGURATION FOR MICRO-AND MILLIMETER- WAVE SIGNALS" IEEE MICROWAVE AND GUIDED WAVE LETTERS, IEEE INC, NEW YORK, US, Bd. 6, Nr. 7, 1. Juli 1996 (1996-07-01), Seiten 265-267, XP000590134 ISSN: 1051-8207

## Beschreibung

Die vorliegende Erfindung betrifft ein Mobilfunkgerät mit einer Schaltungsanordnung zur Frequenzumsetzung.

Zum Umsetzen von Sende- und Empfangssignalen von einem Basisband in eine hochfrequente Lage beziehungsweise umgekehrt werden üblicherweise Hochfrequenzmischer eingesetzt, welche zur Frequenzumsetzung ein Trägersignal benötigen. Dieses Trägersignal wird normalerweise von einem Oszillator, beispielsweise einem spannungsgesteuerten Oszillator, bereitgestellt. Der oszillator schwingt jedoch normalerweise nicht auf der für den Mischer erforderlichen Trägerfrequenz, sondern auf einer anderen Frequenz, damit Rückwirkungen der Sendefrequenz auf den Oszillator verringert sind. Bei der Frequenzumsetzung des Oszillatorsignals ist dabei auf geringe Stromaufnahme und geringes Phasenrauschen des Frequenzumsetzers zu achten.

Die Frequenzumsetzung von der Oszillatorfrequenz zu der für den eigentlichen Nutzsignal-Frequenzumsetzer erforderlichen Trägerfrequenz erfolgt beispielsweise dadurch, daß die Oszillatorfrequenz in einem Frequenzmischer mit sich selbst, gegebenenfalls phasenverschoben, oder mit einem von ihr abgeleiteten, heruntergeteilten und gefilterten Signal gemischt wird. Für das Herunterteilen der Oszillatorfrequenz bieten sich ganzzahlige Teilerverhältnisse an. Die Filterung des bereits heruntergeteilten Oszillatorsignals dient dazu, unerwünschte Signalanteile am Ausgang des Mischers zu vermeiden, welche durch das Mischen höherer Harmonischer entstehen könnten. Dabei kann, abhängig von dem verfolgten Konzept des Senders oder Empfängers, die Spiegelfrequenz, die im Mischer zur Aufbereitung des Oszillatorsignals entsteht, durch Ausbildung des Mischers in einer Spiegelfrequenz unterdrückenden Architektur ausgelöscht werden. Diese Unterdrückung ist jedoch stark abhängig von den Paarungstoleranzen im Frequenzmischer, welche wiederum hohe Anforderungen an Fertigungstoleranzen stellen und außerdem zu einem verhältnismäßig großen Stromverbrauch, schlechten Phasenrauscheigenschaften und großem Flächenbedarf des Frequenzumsetzers, der insgesamt aufwendig zu realisieren ist, führen.

In dem Dokument DE 19710490 A1 ist eine Frequenzumwandlungsschaltung angegeben, welche zwei Frequenzmischer umfaßt. Der erste Frequenzmischer multipliziert ein Eingangssignal mit einem Lokaloszillatorsignal, dem zweiten, dem ersten nachgeschalteten Frequenzmischer wird das Lokaloszillatorsignal frequenzgeteilt zugeführt.

Das Dokument US 3,605,023 betrifft einen Frequenzteiler. Figur 2 zeigt einen Frequenzteiler zur Frequenzteilung durch fünf. Hierfür sind zwei kaskadierte durch zwei-Frequenzteiler einem symmetrischen Modulator nachgeschaltet. Der Ausgang dieser Anordnung ist mit dem anderen Eingang des Modulators verbunden. Die dort verwendeten durch zwei-Frequenzteiler selbst umfassen je einen weiteren symmetrischen Modulator mit der in Figur 1 des Dokuments US 3,605,023 gezeigten Verschaltung.

Das Dokument US 2001/0054919 A1 beschreibt einen Frequenzmultiplizierer. Dieser weist ein Exclusive-OR Gatter auf, dessen Ausgang über einen Frequenzteiler mit einem der Eingänge des Exclusive-OR Gatters verbunden ist. Der Frequenzteiler umfasst zwei Flipflops. Der Frequenzmultiplizierer ist bevorzugt in einer Current Mode Logic (CML) - Schaltungstechnik realisiert.

Aufgabe der vorliegenden Erfindung ist es daher, ein Mobilfunkgerät mit einer Schaltungsanordnung anzugeben, welche eine Frequenz-umsetzung mit geringerem Stromverbrauch der Schaltung und geringerer, erforderlicher Chipfläche ermöglichen.

Erfindungsgemäß wird die Aufgabe gelöst durch ein Mobilfunkgerät mit einer Schaltungsanordnung zur Frequenzumsetzung mit den Merkmalen des Patentanspruchs 1.

Gemäß dem vorgestellten Prinzip wird ein Frequenzmischer zur Frequenzumsetzung eines Eingangssignals benutzt. Dieser mischt jedoch nicht die Eingangsfrequenz mit sich selbst, gegebenenfalls phasenverschoben, oder mit einer von ihr durch Frequenzteilung abgeleiteten Frequenz, sondern vielmehr ist ein Rückkopplungspfad gebildet, in dem ein Frequenzteiler angeordnet ist, der mit einem weiteren Eingang des Frequenzmischers gekoppelt ist. Der Frequenzmischer mischt demnach das Eingangssignal, welches die Eingangsfrequenz hat, mit einem vom Ausgangssignal mit der Ausgangsfrequenz abgeleiteten Signal. Dieses wird durch Frequenzteilung des Ausgangssignals bereitgestellt.

Das vorliegende Prinzip hat den Vorteil, daß sich höhere Harmonische des heruntergeteilten Ausgangssignals im Mischer auf die Gleichtaktlage herunterfalten. Dem Mischer nachgeschaltet kann dann ein einfaches Filter vorgesehen sein, welches die verbleibenden, unerwünschten Signale dämpft.

Insgesamt ermöglicht das vorgeschlagene Prinzip die Verwendung eines Frequenzmischers zur Frequenzumsetzung des Oszillatorsignals, an den deutlich geringere Linearitätsanforderungen gestellt werden müssen. Deshalb kann der Mischer besonders stromsparend ausgelegt werden. Da die entstehende Spiegelfrequenz weit genug von der Sendefrequenz, das heißt von der Ausgangsfrequenz der Schaltungsanordnung entfernt liegt, kann diese mit einem einfachen Filter gedämpft werden.

Besonders vorteilhaft in Bezug auf Stromverbrauch und benötigte Chipfläche erweist sich die Auslegung des Frequenzteilers mit dem Teilerfaktor zwei. Das heißt, daß der Frequenzteiler den zweiten Eingang des Frequenzmischers ein Signal mit der halben Ausgangsfrequenz zuführt.

Am Ausgang des Frequenzmischers ist in diesem Fall ein Signal mit einer Frequenz bereitgestellt sich eine Frequenz, die sich aus der Differenz der Eingangsfrequenz und der halben Ausgangsfrequenz ergibt. Die Spiegelfrequenz, welche es zu unterdrücken gilt, ergibt sich hier aus der Summe von Eingangsfrequenz, also üblicherweise Oszillatorfrequenz, und der halben Ausgangsfrequenz der Schaltungsanordnung. Bei einer Frequenzteilung mit dem ganzzahligen Teilerwert n=2 in der Frequenzrückkopplung sind der Stromverbrauch und die benötigte Chipfläche im Vergleich zu den eingangs genannten Frequenzumsetzungsschaltungen halbiert.

Eine besonders vorteilhafte Ausführungsform der vorliegenden Schaltungsanordnung ergibt sich durch Ausbilden des Frequenzteilers mit einem Flipflop. In diesem Fall wird bevorzugt der Takteingang des Flipflops mit dem Ausgang der Schaltungsanordnung zur Frequenzumsetzung verbunden. Zwischen Eingang und Ausgang des Flipflops ist bevorzugt ein geschlossener Rückkopplungspfad gebildet. Der Ausgang des Flipflops ist mit dem zweiten Eingang des Frequenzmischers verbunden.

Eine weitere, vorteilhafte Ausführungsform der vorliegenden Erfindung umfaßt zwischen Ausgang des Frequenzmischers und Eingang des Frequenzteilers, und damit auch vor dem Ausgang der Schaltungsanordnung, ein Mittel zur Gleichanteilentkopplung, das heißt zur DC-Entkopplung des Ausgangssignals des Frequenzmischers. Hierdurch werden mit Vorteil Gleichtakt-Anteile, die durch Mischen des heruntergeteilten Ausgangssignals mit dem Eingangssignal entstehen können, unterdrückt.

Das Mittel zur Gleichanteilentkopplung ist bevorzugt als Kondensator ausgebildet, welcher in Serie im Signalpfad geschaltet ist.

Bezüglich des Mobilfunkgerätes ist die Aufgabe gelöst durch ein Mobilfunkgerät mit einer Schaltungsanordnung wie vorstehend beschrieben, aufweisend
- zumindest eine Einrichtung zur Frequenzumsetzung eines Nutzsignals zwischen einer hochfrequenten Lage und einem Basisband mit einem Hilfseingang zum Zuführen eines Signals mit einer Trägerfrequenz,
- einen Frequenzgenerator, der an einem Ausgang ein Bezugssignal mit einer Bezugsfrequenz bereitstellt, und
- die Schaltungsanordnung zur Frequenzumsetzung, die mit ihrem Eingang an den Ausgangs des Frequenzgenerators und mit ihrem Ausgang mit dem Hilfseingang der Einrichtung zur Frequenzumsetzung gekoppelt ist.

Mit der Schaltungsanordnung zur Frequenzumsetzung, wie vorstehend beschrieben, wird die von einem Oszillator bereitgestellte Bezugsfrequenz in ein Signal mit einer anderen Frequenz umgesetzt, damit eine Rückwirkung des Sendesignals auf den Frequenzgenerator möglichst gering ist. Mit diesem Signal wird eine Einrichtung zur Frequenzumsetzung eines Nutzsignals an einem Hilfseingang gespeist, welche entweder zum Umsetzen eines Basisbandsignals in eine hochfrequente Lage oder umgekehrt ausgelegt ist.

Anstelle der beschriebenen Ansteuerung eines Nutzsignal-Frequenzumsetzers, der eine Direktumsetzung zwischen hochfrequenter Lage und Basisband oder umgekehrt bewirkt, kann eine Frequenzumsetzungsschaltung gemäß vorliegendem Prinzip mit Vorteil im Rahmen der Erfindung auch bei heterodynen Transceiverarchitekturen oder bei reinen Sende- oder Empfangsarchitekturen eingesetzt werden.

Weitere Einzelheiten und vorteilhafte Ausgestaltungen der vorliegenden Erfindung sind Gegenstand der Unteransprüche.

Die Erfindung wird nachfolgend an mehreren Ausführungsbeispielen anhand der Zeichnungen näher erläutert.

Es zeigen:
- Figur 1: ein erstes Ausführungsbeispiel des vorliegenden Prinzips anhand eines vereinfachten Blockschaltbildes mit einem N-Frequenzteiler,
- Figur 2: eine weitere Ausführungsform des vorliegenden Prinzips anhand eines Blockschaltbildes mit einer Frequenzteilung durch zwei, und
- Figur 3: ein Mobilfunkgerät mit einer Schaltungsanordnung zur Frequenzumsetzung gemäß Figur 1 oder 2.

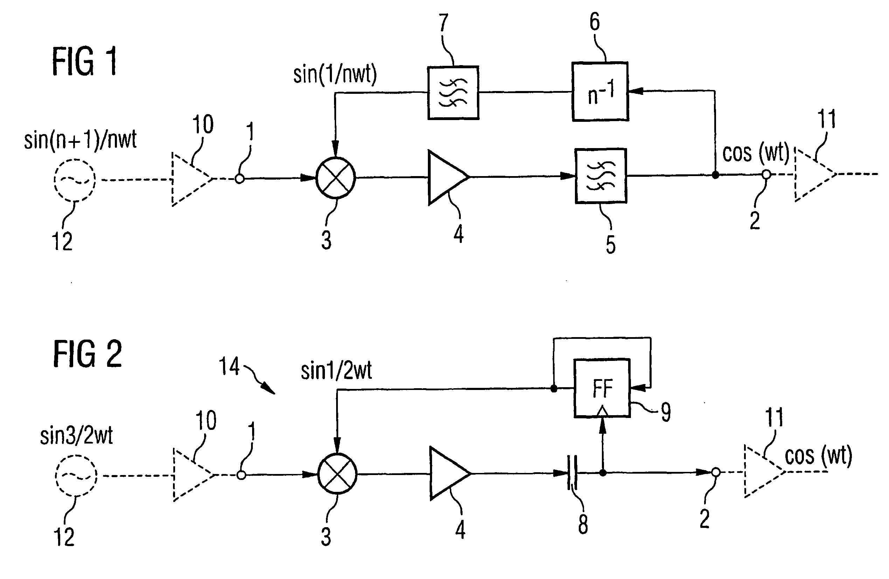

Figur 1 zeigt eine Schaltungsanordnung zur Frequenzumsetzung mit einem Eingang 1 zum Zuführen eines Eingangssignals mit einer Eingangsfrequenz, mit einem Ausgang 2, an dem ein Ausgangssignal mit einer von der Eingangsfrequenz abhängigen Ausgangsfrequenz abgreifbar ist und mit einem Frequenzmischer 3. Der Frequenzmischer 3 ist ausgebildet mit einem ersten Eingang, der mit dem Eingang 1 der Umsetzungsschaltung verbunden ist, mit einem weiteren Eingang und mit einem Ausgang. Der Ausgang des Frequenzmischers 3 ist über einen Verstärker 4 und ein Bandpaßfilter 5 an den Ausgang 2 der Schaltungsanordnung angeschlossen. Weiterhin ist ein Rückkopplungspfad vom Ausgang 2 der Schaltung auf den weiteren Eingang des Frequenzmischers 3 vorgesehen, der einen Frequenzteiler 6 mit nachgeschaltetem Bandpaßfilter 7 umfaßt. Hierbei ist der Eingang des Frequenzteilers 6 mit dem Ausgang der Schaltung 2 verbunden, während der Ausgang des Filters 7 mit dem weiteren Eingang des Mischers 3 verbunden ist.

Ein spannungsgesteuerter Oszillator 12 ist über einen optionalen Verstärker 10 an den Eingang 1 der Schaltungsanordnung angeschlossen. Ebenso ist an den Ausgang 2 ein weiterer Verstärker 11 angeschlossen, der eine weitere Signalverarbeitungskette repräsentieren soll. Der Oszillator 12 stellt ein sinusförmiges, hochfrequentes Signal mit der Kreisfrequenz (N+1)/N*ω bereit. Dieses wird im Frequenzmischer 3 umgesetzt in ein kosinusförmiges, hochfrequentes Signal mit der Kreisfrequenz ω. Hierfür stellt der Frequenzteiler 6, der das Ausgangssignal mit dem Frequenzteiler N teilt, an dem weiteren Eingang des Mischers 3 ein sinusförmiges Signal mit der Kreisfrequenz 1/Nω bereit.

Aufgrund der geringen Linearitätsanforderungen an den Mischer 3 ist gemäß vorliegendem Prinzip ein besonders stromsparendes Frequenzumsetzen möglich. Deshalb ist die Frequenzumsetzungsschaltung gemäß Figur 1 insbesondere zum Betrieb in Mobilfunkgeräten und dort zur Bereitstellung einer Trägerfrequenz oder Lokaloszillatorfrequenz geeignet.

Figur 2 zeigt eine Weiterbildung der Schaltungsanordnung von Figur 1, welche in Aufbau und Funktionsweise weitgehend derjenigen von Figur 1 entspricht und insoweit an dieser Stelle nicht noch einmal beschrieben werden soll. Lediglich der :N-Frequenzteiler 6 ist durch einen :2-Frequenzteiler 9 ersetzt, der ein eingangsseitig anliegendes Signal an seinem Ausgang mit halber Frequenz abgibt. Weiterhin ist das Bandpaßfilter 7 im Rückkopplungspfad der Schaltung 14 zur Frequenzumsetzung gemäß Figur 2 durch einen Kurzschluß ersetzt. Schließlich ist das Bandpaßfilter 5 im Vorwärtspfad durch einen Serienkondensator 8 ersetzt. Der Kondensator 8 verbindet den Ausgang des Verstärkers 4 mit dem Ausgang 2 der Schaltungsanordnung. Der :2-Frequenzteiler 9 ist als Flipflop ausgebildet, welches einen Takteingang, einen Dateneingang und einen Datenausgang umfaßt. Der Ausgang 2 der Schaltungsanordnung ist mit dem Takteingang des Frequenzteilers 9 verbunden. Dateinein- und
- ausgang des Flipflops sind in einer weiteren Rückkopplung miteinander kurzgeschlossen. Der Ausgang des Flipflops ist mit dem weiteren Eingang des Mischers 3 verbunden.

Bei der Schaltungsanordnung gemäß Figur 2 stellt der Oszillator 12 eine Eingangsfrequenz bereit, welche durch die Kreisfrequenz 3/2ω repräsentiert wird. Das Oszillatorsignal hat einen sinusförmigen Verlauf. Am Ausgang 2 der Schaltung stellt der Mischer 3 ein Ausgangssignal mit der Kreisfrequenz ω bereit. Dies wird dadurch erzielt, daß der :2-Frequenzteiler 9 das Signal mit der Kreisfrequenz ω in ein sinusförmiges Signal der Kreisfrequenz ω/2 teilt, welches mit der Oszillator-Signalfrequenz 3/2ω gemischt wird. Die Spiegelfrequenz, die sich aus der Summe der Eingangsfrequenzen ergibt und bei 2ω liegt, ist weit genug von der Sendefrequenz entfernt, um durch ein einfaches Filter gedämpft werden zu können. Die Oberwellen des heruntergeteilten Ausgangssignals falten sich im Mischer 3 zumindest zum Teil auf die Gleichtaktlage herunter und werden mit dem Kondensator 8 in einfacher Weise vom Ausgang 2 entkoppelt.

Im Vergleich zu bisher bekannten Frequenzumsetzungsschaltungen ist bei vorliegender Ausführung mit einem Frequenzteilerverhältnis von zwei ein halbierter Stromverbrauch und eine Halbierung der benötigten Chipfläche erzielt.

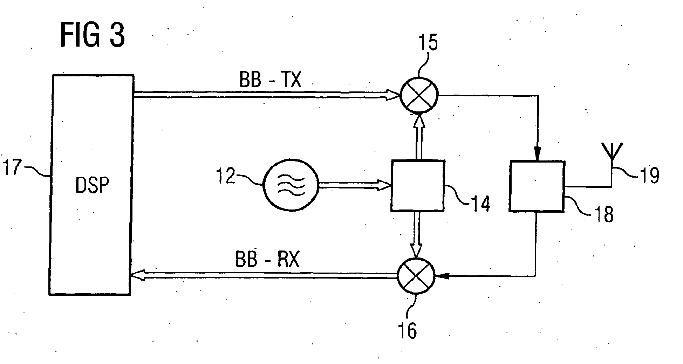

Figur 3 schließlich zeigt die Anwendung der Frequenzumsetzungsschaltung von Figur 2 in einem Mobilfunk-Transceiver. Dabei ist ein Aufwärts-Frequenzmischer 15 in einem Sendepfad, sowie ein Abwärts-Frequenzmischer 16 in einem Empfangspfad des Mobilfunkgerätes vorgesehen. Der Aufwärts-Frequenzumsetzer 15 weist einen Modulationseingang zum Zuführen eines im Basisband vorliegenden Modulationssignals BB-TX auf und ist mit einem digitalen Signalprozessor 17 gekoppelt, der das Modulationssignal im Basisband bereitstellt. Am Ausgang des Aufwärts-Frequenzumsetzers 15 steht das Modulationssignal als in eine hochfrequente Lage konvertierter, modulierter Träger bereit. Der Ausgang des Aufwärts-Frequenzmischers 15 ist mit einer Duplexeinheit 18 gekoppelt, welche wiederum bidirektional an eine Antenne 19 angeschlossen ist. Die Duplexeinheit 18 ist weiterhin in Empfangsrichtung an einem Ausgang an einen Hochfrequenzeingang des Abwärts-Frequenzmischers 16 zum Zuführen eines hochfrequenten Empfangssignals angeschlossen. Der Ausgang des Abwärts-Frequenzmischers 16 ist mit einem Eingang des digitalen Signalprozessors 17 verbunden, dem dabei ein demoduliertes, ins Basisband heruntergemischtes Empfangssignal BB-RX zugeführt wird. Zur Ansteuerung der Frequenz-Mischer 15, 16 mit einem Trägersignal ist ein spannungsgesteuerter Oszillator 12, der auch eine Phasenregelschleife umfassen kann, vorgesehen. Dieser spannungsgesteuerte Oszillator 12 ist über die Schaltungsanordnung zur Frequenzumsetzung 14 an je einen Hilfseingang der Mischer 15, 16 angeschlossen. Demnach wird die Schwingfrequenz des Oszillators 12 den Hilfseingängen der Mischer 15, 16 aufbereitet zugeführt.

Insbesondere bei mobilen Anwendungen sind die Eigenschaften der vorliegenden Frequenzumsetzungsschaltung, wie geringe Stromaufnahme und geringe Chipfläche, von besonderer Bedeutung. Der Oszillator 12 kann bei halber Schwingfrequenz arbeiten, so daß eine weitere Vereinfachung des Schaltungslayouts gewährleistet ist.

Anstelle der gezeigten Direktumsetzungsarchitektur des Mobilfunkgerätes können, insbesondere in Bezug auf den Empfangszweig des Transceivers gemäß Figur 3, auch heterodyne Architekturen sowie Low-IF-Architekturen vorteilhaft mit der erfindungsgemäßen Frequenz-Umsetzungsschaltung ausgestattet sein.

### Bezugszeichenliste

- 1: Eingang
- 2: Ausgang
- 3: Frequenzmischer
- 4: Verstärker
- 5: Filter
- 6: Frequenzteiler
- 7: Filter
- 8: Kondensator
- 9: Flipflop
- 10: Verstärker
- 11: Verstärker
- 12: Frequenzgenerator, VCO
- 14: Frequenzumsetzungsschaltung
- 15: Frequenzumsetzer
- 16: Frequenzumsetzer
- 17: digitaler Signalprozessor
- 18: Duplexeinheit
- 19: Antenne

## Patentansprüche

1. Mobilfunkgerät, aufweisend
- zumindest eine Einrichtung zur Frequenzumsetzung (15, 16) eines Nutzsignals zwischen einer hochfrequenten Lage und einem Basisband mit einem Hilfseingang zum Zuführen eines Signals mit einer Trägerfrequenz,
- einen Frequenzgenerator (12), der als spannungsgesteuerter Oszillator ausgebildet ist und an einem Ausgang ein Bezugssignal mit einer Bezugsfrequenz bereitstellt, und
- eine Schaltungsanordnung, zur Frequenzumsetzung (14), die mit ihrem Eingang an den Ausgang des Frequenzgenerators (12) und mit ihrem Ausgang mit dem Hilfseingang der zumindest einen Einrichtung zur Frequenzumsetzung (15, 16) gekoppelt ist, bei der die Schaltungsanordnung zur Frequenzumsetzung (14), aufweist :
- einen Eingang (1) zum Zuführen eines Eingangssignals mit einer Eingangsfrequenz,
- einen Ausgang (2), an dem ein Ausgangssignal mit einer von der Eingangsfrequenz abhängigen Ausgangsfrequenz abgreifbar ist,
- einen Frequenzmischer (3) mit einem ersten Eingang, der an den Eingang (1) der Schaltungsanordnung angeschlossen ist, mit einem zweiten Eingang und mit einem Ausgang, der mit dem Ausgang (2) der Schaltungsanordnung gekoppelt ist, und
- einen Frequenzteiler (6) angeordnet in einem Rückführungspfad der Schaltungsanordnung und ausgebildet zur Abgabe eines Signals mit einer aus der Ausgangsfrequenz heruntergeteilten Frequenz, wobei der Frequenzteiler (6) einen mit dem Ausgang (2) der Schaltungsanordnung verbundenen Eingang und einen mit dem zweiten Eingang des Frequenzmischers (3) gekoppelten Ausgang aufweist, wobei
die Eingangsfrequenz das (n+1) /n-fache der Ausgangsfrequenz bei einem Teilerwert n des Frequenzteilers (6) beträgt.

2. Mobilfunkgerät nach Anspruch 1,
**dadurch gekennzeichnet, daß** der Frequenzteiler (6) als Frequenzteiler mit dem Teilerfaktor zwei ausgebildet ist.

3. Mobilfunkgerät nach Anspruch 1 oder 2,
**dadurch gekennzeichnet, daß** der Frequenzteiler (6) ein Flipflop (9) umfaßt.

4. Mobilfunkgerät nach Anspruch 3,
**dadurch gekennzeichnet, daß** das Flipflop (9) einen Takteingang aufweist, der den Eingang des Frequenzteilers bildet.

5. Mobilfunkgerät nach Anspruch 3 oder 4, **dadurch gekennzeichnet, dass** das Flipflop (9) einen Dateneingang und einen Datenausgang umfasst, die miteinander kurzgeschlossen sind.

6. Mobilfunkgerät nach einem der Ansprüche 1 bis 5, **dadurch gekennzeichnet, daß** zwischen den Ausgang des Frequenzmischers (3) und den Eingang des Frequenzteilers (6) ein Mittel zur Gleichanteilentkopplung (5) des Ausgangssignals der Schaltungsanordnung geschaltet ist.

7. Mobilfunkgerät nach Anspruch 6, **dadurch gekennzeichnet, daß** das Mittel zur Gleichanteilentkopplung (5) ein Kondensator (8) ist.

8. Mobilfunkgerät nach einem der Ansprüche 1 bis 7, **dadurch gekennzeichnet, dass** dem Frequenzteiler (6) ein Bandpassfilter (7) nachgeschaltet ist.

## Claims

1. Mobile radio, having
- at least one device for frequency conversion (15, 16) of a useful signal between a radio frequency and a baseband, having an auxiliary input for supplying a signal at a carrier frequency,
- a frequency generator (12) which is in the form of a voltage controlled oscillator and provides, at an output, a reference signal at a reference frequency, and
- a circuit arrangement for frequency conversion (14), whose input is coupled to the output of the frequency generator (12) and whose output is coupled to the auxiliary input of the at least one device for frequency conversion (15, 16), in which the circuit arrangement for frequency conversion (14) has:
- an input (1) for supplying an input signal at an input frequency,
- an output (2) at which it is possible to tap off an output signal at an output frequency which is dependent on the input frequency,
- a frequency mixer (3) having a first input, which is connected to the input (1) of the circuit arrangement, having a second input and having an output which is coupled to the output (2) of the circuit arrangement, and
- a frequency divider (6) arranged in a feedback path in the circuit arrangement and designed to output a signal at a frequency divided down from the output frequency, the frequency divider (6) having an input connected to the output (2) of the circuit arrangement and an output coupled to the second input of the frequency mixer (3), where the input frequency is (n+1)/n times the output frequency for a divider value n on the frequency divider (6).

2. Mobile radio according to Claim 1,
**characterized in that**
the frequency divider (6) is in the form of a frequency divider with the division factor 2.

3. Mobile radio according to Claim 1 or 2,
**characterized in that**
the frequency divider (6) comprises a flipflop (9).

4. Mobile radio according to Claim 3,
**characterized in that**
the flipflop (9) has a clock input which forms the input of the frequency divider.

5. Mobile radio according to Claim 3 or 4,
**characterized in that**
the flipflop (9) comprises a data input and a data output which are shorted together.

6. Mobile radio according to one of Claims 1 to 5,
**characterized in that**
the output of the frequency mixer (3) and the input of the frequency divider (6) have a means connected between them for DC component decoupling (5) for the output signal from the circuit arrangement.

7. Mobile radio according to Claim 6,
**characterized in that**
the means for DC component decoupling (5) is a capacitor (8).

8. Mobile radio according to one of Claims 1 to 7,
**characterized in that**
a bandpass filter (7) is provided downstream of the frequency divider (6).

## Revendications

1. Appareil de téléphonie mobile comprenant
- au moins un dispositif (15, 16) de conversion de la fréquence d'un signal utile entre une position en haute fréquence et une bande de base, ayant une entrée auxiliaire pour l'apport d'un signal ayant une fréquence porteuse,
- un générateur (12) de fréquence, qui est constitué sous la forme d'un oscillateur commandé par la tension et qui procure, à une sortie, un signal de référence ayant une fréquence de référence, et
- un montage de conversion (14) de fréquence, qui est couplé par son entrée à la sortie du générateur (12) de fréquence et par sa sortie à l'entrée auxiliaire du au moins un dispositif (15, 16) de conversion de la fréquence,
dans lequel le montage de conversion (14) de la fréquence comporte :
- une entrée (1) d'apport d'un signal d'entrée ayant une fréquence d'entrée,
- une sortie (2) à laquelle peut être prélevé un signal de sortie ayant une fréquence de sortie qui dépend de la fréquence d'entrée,
- un mélangeur (3) de fréquence, ayant une première entrée qui est raccordé à l'entrée du montage, ayant une deuxième entrée et une sortie qui est couplée à la sortie (2) du montage, et
- un diviseur (6) de fréquence, disposé dans un trajet de retour du montage et constitué pour émettre un signal ayant une fréquence divisée à partir de la fréquence de sortie, le diviseur (6) de fréquence ayant une entrée reliée à la sortie (2) du montage et une sortie couplée à la deuxième entrée du mélangeur (3) de fréquence,
dans lequel
la fréquence d'entrée représente (n+1)/n fois la fréquence de sortie pour une valeur n de division du diviseur (6) de fréquence.

2. Appareil de téléphonie mobile suivant la revendication 1, **caractérisé en ce que** le diviseur (6) de fréquence est constitué en diviseur de fréquence ayant un facteur de division de 2.

3. Appareil de téléphonie mobile suivant la revendication 1 ou 2, **caractérisé en ce que** le diviseur (6) de fréquence comprend une bascule (9).

4. Appareil de téléphonie mobile suivant la revendication 3, **caractérisé en ce que** la bascule a une entrée d'horloge, qui forme l'entrée du diviseur de fréquence.

5. Appareil de téléphonie mobile suivant la revendication 3 ou 4, **caractérisé en ce que** la bascule (9) comprend une entrée de données et une sortie de données, qui sont court-circuitées entre elles.

6. Appareil de téléphonie mobile suivant l'une des revendications 1 à 5, **caractérisé en ce qu'**il est monté, entre la sortie du mélangeur (3) de fréquence et l'entrée du diviseur (6) de fréquence, un moyen (5) de découplage de la composante continue du signal de sortie du montage.

7. Appareil de téléphonie mobile suivant la revendication 6, **caractérisé en ce que** le moyen (5) de découplage de la composante continue est un condensateur (8).

8. Appareil de téléphonie mobile suivant l'une des revendications 1 à 7, **caractérisé en ce qu'**un filtre (7) passe-bande est monté en aval du diviseur (6) de fréquence.
